# EUROPEAN PATENT SPECIFICATION

(11) **EP 3 528 282 B1**
(45) Date of publication and mention of the grant of the patent: **08.01.2025**
(21) Application number: 18204405.7
(22) Date of filing: 05.11.2018
(51) Int. Cl.: H01L 23/367, G03B 17/55, H05K 7/20, H04N 23/52

(54) **ELECTRONIC DEVICE WITH COOLING**
ELEKTRONISCHE VORRICHTUNG MIT KUEHLUNG
DISPOSITIF ÉLECTRONIQUE AVEC REFROIDISSEMENT

(30) Priority: 14.11.2017 JP 2017219405; 01.10.2018 JP 2018186379
(43) Date of publication of application: 21.08.2019
(73) Proprietor: Canon Kabushiki Kaisha, Tokyo 146-8501 (JP)
(72) Inventor: FURUYA, Takahiro, Tochigi (JP)
(74) Representative: TBK

(56) References cited:
- RU-C1- 2 440 702
- US-A- 6 072 697
- US-A1- 2014 198 457
- US-B2- 7 706 684

## Description

### FIELD

Embodiments described herein relate generally to an electronic device.

### BACKGROUND

Document RU 2 440 702 C1 discloses an electronic device where each of substrates is inserted into one hollow fin. The structure is also so that each substrate is sandwiched in a non-contact manner between the inner walls of the hollow fin.

Documents US 6 072 697 A and US 2014/198457 A1 disclose electronic devices, where a single substrate is inserted per fin.

In electronic devices, such as industrial cameras, electronic components or the like provided inside casings generate heat, and it is necessary to appropriately dissipate the heat. For example, from the viewpoint of preventing degradation or breakdown of the electronic components or the like provided inside the casings, in some cases, a performance guarantee temperature corresponding to the upper limit temperature inside the casings may be determined. In addition, with regard to electronic devices that may be touched by hands of users, in some cases, the upper limit temperature of surfaces of casings may be determined from the viewpoint of preventing low temperature burn or the like.

Conventionally, in electronic devices, a performance guarantee temperature inside the casings and the upper limit temperature of the surfaces of the casings as described above have been maintained by minor design innovation. However, with improvement of performance and functions of the electronic devices, power consumption is increasing and the amount of heat generation is increasing.

According to the invention, an electronic device is defined by any of independent claims 1 to 3. Advantageous embodiments are carried out according to the dependent claims.

### BRIEF DESCRIPTION OF THE DRAWINGS

FIG. 1 is an external perspective view illustrating a configuration example of an electronic device according to a first embodiment;
FIG. 2 is a perspective view illustrating a state in which a top cover of the electronic device is removed;
FIG. 3A is an end view taken along A-A in FIG. 1;
FIG. 3B is a diagram illustrating a first configuration example for preventing an increase in the temperature of an outer surface of a casing;
FIG. 3C is a diagram illustrating a second configuration example for preventing an increase in the temperature of the outer surface of the casing;
FIG. 4 is an external perspective view illustrating a configuration example of an electronic device according to a second embodiment;
FIG. 5 is an external perspective view of a state in which a burn prevention cover is attached to the electronic device;
FIG. 6 is an external perspective view illustrating a configuration example of an electronic device according to a third embodiment;
FIG. 7 is an external perspective view illustrating arrangement that is adopted when the electronic device is used;
FIG. 8 is an external perspective view illustrating a configuration example of an electronic device according to a fourth embodiment;
FIG. 9 is an end view taken along A-A in FIG. 8;
FIG. 10 is an external perspective view illustrating a configuration example of an electronic device according to a fifth embodiment;
FIG. 11 is an end view taken along A-A in FIG. 10;
FIG. 12 is an external perspective view of a state in which a burn prevention cover is attached to the electronic device;
FIG. 13 is an end view illustrating a first configuration example of an electronic device according to a sixth embodiment;
FIG. 14 is an end view illustrating a second configuration example of the electronic device according to the sixth embodiment; and
FIG. 15 is an end view illustrating a third configuration example of the electronic device according to the sixth embodiment.

An electronic device according to an embodiment is recited in claim 1.

Embodiments of an electronic device will be described below with reference to the drawings. The embodiments are not limited to those described below. In addition, contents described in a single embodiment or modification is, in principle, applicable to other embodiments and modifications in the same manner.

### First Embodiment

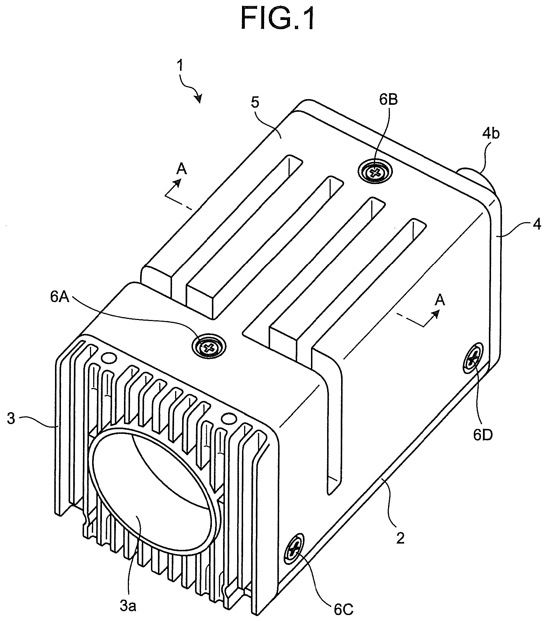

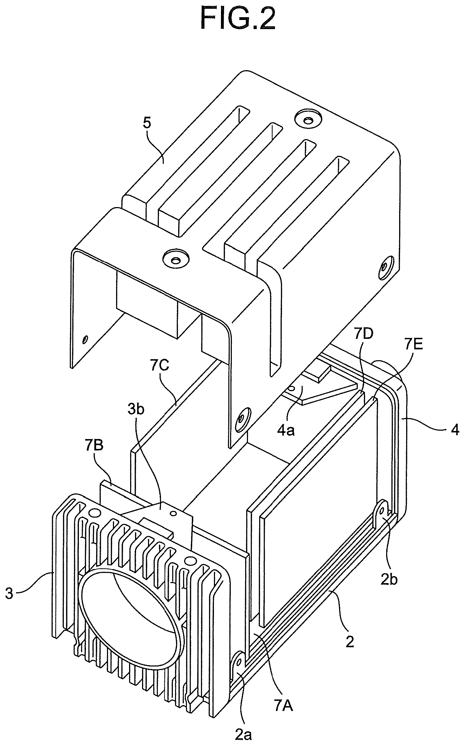

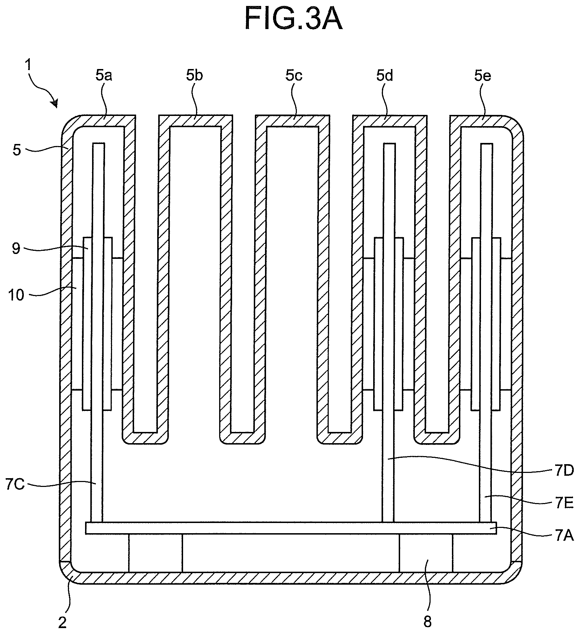

FIG. 1 is an external perspective view illustrating a configuration example of an electronic device 1 according to a first embodiment. The electronic device 1 is assumed to be a camera to which a lens unit (not illustrated) is attached. In FIG. 1, the electronic device 1 has a casing that is formed in an approximately rectangular box shape with a bottom cover 2 that constitutes a bottom surface and a part of side surfaces, a front cover 3 that constitutes a front surface, a back cover 4 that constitutes a back surface, and a top cover 5 that constitutes an upper surface and most of the side surfaces. The bottom cover 2, the front cover 3, the back cover 4, and the top cover 5 are manufactured by thin-wall die casting or the like. A connector receiver 4b for a power cord or the like is provided on the back cover 4. FIG. 2 is a perspective view illustrating a state in which the top cover 5 of the electronic device 1 is removed. FIG. 3A is an end view taken along A-A in FIG. 1.

The front surface may be referred to as a first surface. The back surface that faces the front surface may be referred to as a second surface. The upper surface (top surface) that is perpendicular to the back surface may be referred to as a third surface. The bottom surface that faces the upper surface may be referred to as a fourth surface. A right side surface that is perpendicular to the front surface and the upper surface may be referred to as a fifth surface. A left side surface that faces the right side surface may be referred to as a sixth surface.

In FIG. 1 to FIG. 3A, the bottom cover 2 has a flat plate shape with upward bending portions on the right side surface and the left side surface. Lower ends of the front cover 3 are fixed to front ends (end portions on the front surface side) of the bottom cover 2 with screws or the like, and lower ends of the back cover 4 are fixed to rear ends of the bottom cover 2 with screws or the like. The top cover 5 is fixed to a fixing piece 3b, which is provided on the back side of an upper end of the front cover 3, with a screw 6A, fixed to a fixing piece 4a, which is provided on the back side of an upper end of the back cover 4, with a screw 6B, and fixed to fixing pieces 2a and 2b, which are provided on side surfaces of the bottom cover 2, with screws 6C and 6D.

A substrate 7A including an electronic circuit is fixed on the inner side of a bottom surface of the bottom cover 2 via a spacer 8 such that a substrate surface with the electronic circuit is oriented horizontally. A substrate 7B is fixed in a vertical direction on a front surface side of the substrate surface of the substrate 7A such that a substrate surface of the substrate 7B faces the front surface. In addition, a plurality of substrates 7C, 7D, and 7E are fixed in a vertical direction on the substrate surface of the substrate 7A such that substrate surfaces of the substrates 7C, 7D, and 7E face the side surfaces. While the case is illustrated in which the substrate 7A is indirectly fixed on the inner side of the bottom surface of the bottom cover 2 via the spacer 8, it may be possible to directly fix the substrate 7A to the bottom cover 2.

An opening 3a to which the lens unit is attached is provided in the center of a front surface of the front cover 3, and a heatsink including a plurality of fins is provided around the opening 3a. An image sensor (not illustrated) that is provided on the substrate 7B is arranged on the inner side of the opening 3a of the front cover 3, and the lens unit attached to the opening 3a forms an image of an imaging object on a light receiving surface of the image sensor. The heatsink provided on the front cover 3 is mainly used to dissipate heat from the substrate 7B on which the image sensor is mounted; however, if heat from the substrate 7B can be adequately dissipated using a different heat discharging mechanism, the heatsink of the front cover 3 may be omitted. Meanwhile, an image captured by the image sensor is processed into an image signal by electronic circuits (electronic components) 9 that are arranged on the substrates 7A to 7E, and a final image signal is output to the outside of the device via a connector or the like.

The top cover 5, in itself, is formed into a plurality of fins, and the fins include hollow fins. In this example, a case will be described in which all of the fins are formed into the hollow fins using outer concave and convex patterns of the top cover 5. Fins 5a, 5d, and 5e among hollow fins 5a to 5e are configured such that most parts from ends of the substrates 7C, 7D, and 7E are accommodated (inserted) in inner hollow portions thereof. Here, a state in which the most parts of the substrates are accommodated indicates a state in which, for example, more than halves of the electronic circuits 9 provided on the substrates are accommodated. Further, each of the substrates 7C, 7D, and 7E is sandwiched between inner walls of each of the hollow fins 5a, 5d, and 5e in a contact or non-contact manner. Furthermore, each of the substrates 7C, 7D, and 7E is arranged approximately parallel to the inner walls of each of the hollow fins 5a, 5d, and 5e.

While the case is illustrated in which the substrates 7C, 7D, and 7E are accommodated in the fins 5a, 5d, and 5e and substrates are not accommodated in the fins 5b and 5c, it may be possible to accommodate substrates in all of the fins 5a to 5e, or it may be possible not to accommodate a fin different from the fins indicated in the drawings, depending on circuit configurations. It may be possible to accommodate, in the hollow fin in which the substrate is not accommodated, a signal line to which an electronic circuit included in the image sensor or the substrate is connected. However, because the outer fins 5a and 5e are likely to be exposed to the air and increase a heat dissipate effect, it is preferable to preferentially accommodate, in the outer fins 5a and 5e, substrates mounted with electronic circuits that generate large amounts of heat.

Further, the electronic circuits 9 provided on the substrates 7C, 7D, and 7E that are accommodated in the inner hollow portions of the fins 5a, 5d, and 5e are thermally connected to the inner walls of the fins 5a, 5d, and 5e via heat-transfer members 10 that are made with silicone-type or acrylic-type heat-transfer sheet. In FIG. 3A, the electronic circuits 9 are thermally connected to the inner walls of the fins 5a, 5d, and 5e via the heat-transfer members 10 on both surfaces of each of the substrates 7C, 7D, and 7E, but may be thermally connected to only one surfaces. If the heat dissipate effect can be adequately achieved only by accommodating the substrates in the hollow portions of the fin 5a and the other fines, it may be possible to omit thermal connections using the heat-transfer members 10.

While the case has been described in which the five fins 5a to 5e are provided, the number of the hollow fins is not limited to five, but may be changed arbitrarily if needed. Further, widths of the inner hollow portions of the hollow fins in a side-surface direction and widths between the adjacent hollow fins need not be uniform, but may be changed arbitrarily. However, the width of the inner hollow portion of each of the fins in the side-surface direction needs to be set such that a substrate can be accommodated and such that when the heat-transfer member 10 is used, thicknesses of the substrate, components, and the heat-transfer member 10 are taken into account. Further, it is preferable to set the width between the adjacent hollow fins in the side-surface direction to be equal to or larger than a certain width so as not to cause thermal boundaries (boundaries between portions in which convection occurs and portions in which convection does not occur) to overlap with each other and so as not to impede thermal convection. The top cover 5 is one example of a first member that corresponds to at least the third surface, the fifth surface, and the sixth surface and that includes the plurality of fins. The bottom cover 2 is one example of a second member that corresponds to the fourth surface.

It may be possible to cover openings of concave portions of the hollow fins with, for example, breathable mesh members to prevent the concave portions from being clogged with dust or the like.

Here, a heat flow rate in the case of heat discharging in the present embodiment will be described. In general, a heat flow rate from the casing is represented as follows. Heat flow rate = surface area × heat transfer coefficient × (surface temperature - outside air temperature)

The heat flow rate is an amount of heat dissipated from the casing to the outside air per unit time. The surface area is an area in which the casing is exposed to the outside air. The heat transfer coefficient is the amount of heat transfer due to natural convection of air per unit time and per unit difference of temperature. The surface temperature is the temperature of the surface of the casing. The outside air temperature is the temperature of the outside air.

The surface area of the casing of the electronic device 1 according to the present embodiment is increased due to the plurality of hollow fins 5a to 5e provided on the top cover 5, as compared to a casing with the same external dimension (about 2.3 times larger in the example illustrated in the drawings), and thus contributes to an increase in the heat flow rate. Meanwhile, the hollow fins 5a to 5e are provided by utilizing, for example, a space that is not used in a simple box-like (rectangular solid) casing, so that the size of the casing is not increased as compared to the box-like casing. It is even possible to reduce the external dimension of the casing.

Further, in the present embodiment, heat is dissipated from the electronic circuits 9 that are provided on the both surfaces of the substrates 7C, 7D, and 7E to the casing that is constituted of the top cover 5 and the like via the heat-transfer members 10, so that it is possible to bring the temperature of the top cover 5 close to the temperature of the electronic circuits 9. With this configuration, in the expression of the heat flow rate as described above, a difference between the surface temperature and the outside air temperature is increased, so that the heat dissipate amount is increased. That is, when the present embodiment is adopted, it is expected to further increase the heat flow rate, as compared to a case in which the present embodiment is not adopted, such as a case in which a casing is configured as a simple box-like shape without hollow fins and a heat-transfer member dissipates heat to the casing only from an electronic circuit that faces an inner wall of a substrate that faces an inner wall of the casing. In contrast, most of the electronic circuits 9 that are provided on the both surfaces of the substrates 7C, 7D, and 7E come in contact with the casing due to the heat-transfer members 10, and, from the viewpoint of thermal connection, the electronic circuits 9 are directly exposed to the outside air; therefore, even when the waterproof property and the dust resistance of the casing are improved, it is possible to effectively dissipate heat.

In addition, to further improve the heat dissipate effect of the casing, it is possible to increase the surface area by providing, for example, finer concave and convex patterns on the surface of the casing by emboss processing or the like using coating or surface processing.

Further, it is known that larger-than-necessary heat is generated in a thermally harsh environment. However, in the present embodiment, it is possible to reduce an increase in the temperature of the electronic circuits 9 by increasing the heat dissipate effect.

Meanwhile, from the viewpoint of preventing a user from getting burned, it may be possible to reduce the temperature of the outer surface of the casing that is likely to be touched by the hand of the user. In other words, in the example illustrated in FIG. 3A, it is likely that the temperature of the outer surface of the top cover 5 is increased because heat directly flows from the electronic circuits 9 on the substrates 7C and 7E to the outer surface of the top cover 5 via the heat-transfer members 10. To cope with this situation, it may be possible to reduce the temperature of the outer surface of the casing by causing heat to flow to a portion that is less likely to be touched by the hand of the user.

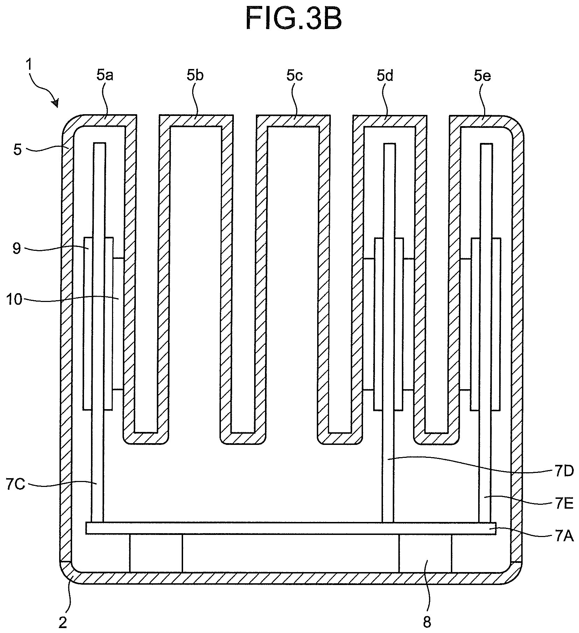

FIG. 3B is a diagram illustrating a configuration example for preventing an increase in the temperature of the outer surface of the casing. In FIG. 3B, with respect to the substrates 7C and 7E accommodated in the fins 5a and 5e that are located on the outer sides in the casing, the electronic circuits 9 facing the outer sides are not provided with the heat-transfer members 10 and not made contact with the inner walls of the top cover 5, but only the electronic circuits 9 facing the inner sides are provided with the heat-transfer members 10. With respect to the fin other than the fins 5a and 5e that are located on the outer sides of the casing, e.g., with respect to the substrate 7D accommodated in the fin 5d, it may be possible to provide the heat-transfer members 10 on the electronic circuits 9 on both sides. With this configuration, it is possible to prevent heat from directly flowing to the outer surface of the top cover 5, and reduce the temperature of the outer surface of the casing that is likely to be touched by the hand of the user.

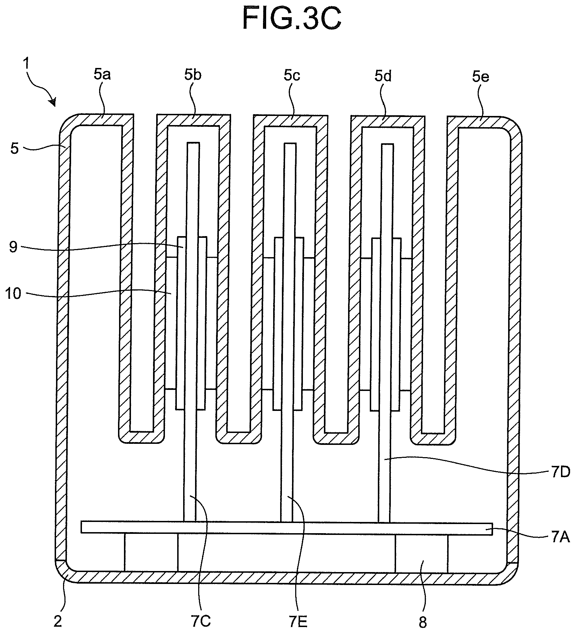

FIG. 3C is a diagram illustrating another configuration example for preventing an increase in the temperature of the outer surface of the casing. FIG. 3C illustrates a case in which the substrates 7C, 7E, and 7D are accommodated preferentially in the fins 5b, 5c, and 5d that are located on the inner side in the casing, and the fins 5a and 5e that are located on the outer sides in the casing are maintained vacant when substrates to be accommodated are not present. In this case, heat that flows to the outer surface of the top cover 5 is reduced, so that it is possible to further reduce the temperature of the outer surface of the casing that is likely to be touched by the hand of the user.

### Second Embodiment

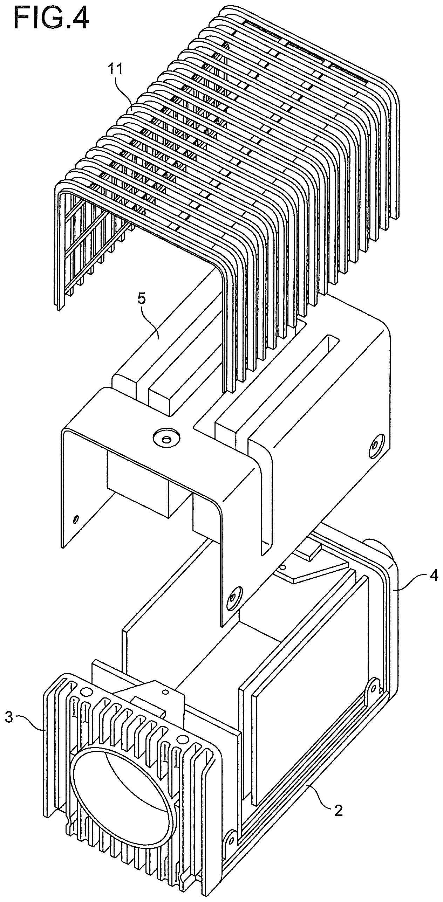

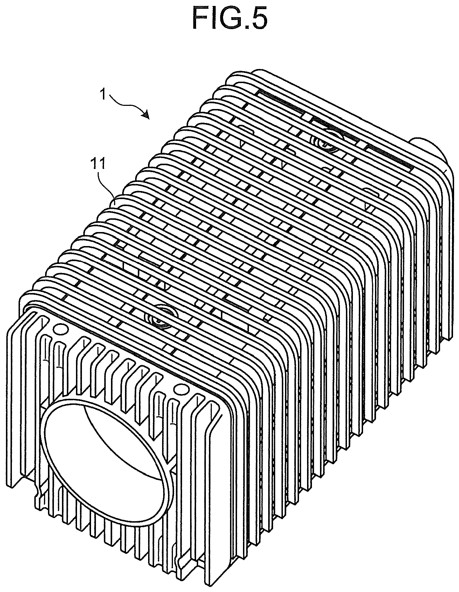

FIG. 4 is an external perspective view illustrating a configuration example of an electronic device 1 according to a second embodiment. In the second embodiment, a burn prevention cover 11 is attachable to the casing of the electronic device 1. FIG. 5 is an external perspective view of a state in which the burn prevention cover 11 is attached to the electronic device 1. A configuration of the casing of the electronic device 1 is the same as illustrated in FIG. 1 to FIG. 3A.

In the first embodiment, the example has been described in which heat is dissipated from the electronic circuits that are provided on the both surfaces of the substrates to the casing via the heat-transfer members, so that it is possible to increase the surface temperature of the casing and it is expected to further increase the heat flow rate. However, in some cases, the upper limit temperature of the surface of the casing is determined from the view point of preventing low temperature burn or the like, and therefore, it is not preferable to merely increase the surface temperature of the casing. To cope with this situation, the second embodiment is configured to allow the burn prevention cover 11 to be attached to maintain the safety even when the surface temperature of the casing is increased.

In FIG. 4 and FIG. 5, the burn prevention cover 11 is made with, for example, resin or the like, and configured such that vertical and horizontal ribs are connected in a mesh-like manner (grid-like manner) to ensure the breathability so as not to impede thermal convection for heat discharging and so as to prevent the top cover 5 from being directly touched with a finger of the hand of a user. The reason why only the top cover 5 is covered by the burn prevention cover 11 is that it is assumed that the temperature of the center of the casing is most increased and the user holds a portion of the top cover 5 by his/her hand. Therefore, if it is assumed that the temperature of a different portion of the casing is considerably increased and the portion may be touched by the hand of the user, the shape of the burn prevention cover 11 is changed so as to cover the portion.

Intervals and thicknesses of the ribs of the burn prevention cover 11 are set to certain sizes such that when the user touches the electronic device 1 (when the user holds the burn prevention cover 11 by his/her hand, for example) the top cover 5 is not directly touched with a finger of the user, e.g, the finger does not slit in a gap between the meshes and the tip of the finger or the like does not touch the top cover 5. The burn prevention cover 11 may be engaged with the casing by a claw or the like (not illustrated) that is provided in a part of the burn prevention cover 11, or may be fixed to the casing with a screw or the like.

The upper limit temperature of the surface of the casing, which is determined from the viewpoint of preventing low temperature burn or the like, is set to 60°C when the surface of the casing is made with metal and set to 75°C when the surface of the casing is made with resin, for example. Therefore, in this example, when the burn prevention cover 11 is made with resin, it is sufficient to reduce the surface temperature of the burn prevention cover 11 to be equal to or lower than 75°C. Resin has a low heat transfer coefficient, and the burn prevention cover 11 is formed in a mesh-like shape with fine ribs with small contact surfaces with the top cover 5; therefore, it is possible to increase the temperature of the top cover 5 up to a temperature higher than the surface temperature of 75°C of the burn prevention cover 11, and it is possible to improve the heat dissipate effect while preventing low temperature burn or the like. However, the temperature of the top cover 5 is restricted by the upper limit temperature that is determined from the viewpoint of preventing degradation or breakdown of electronic circuits and the like in the casing.

### Third Embodiment

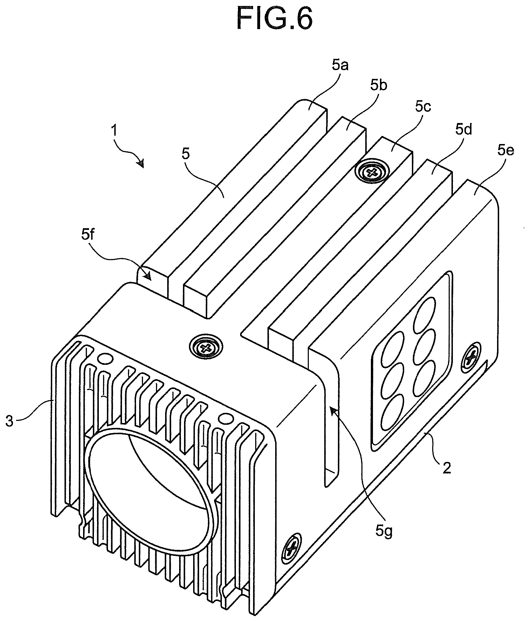

FIG. 6 is an external perspective view illustrating a configuration example of an electronic device 1 according to a third embodiment. In the third embodiment, the shape of the top cover 5 is modified. In other words, the back cover 4 is integrated with the top cover 5 illustrated in FIG. 1 etc., and inter-fin concave portions on end portions of the hollow fins 5a to 5e of the top cover 5 penetrate to the back surface. The end view around the center of the top cover 5 is the same as FIG. 3A.

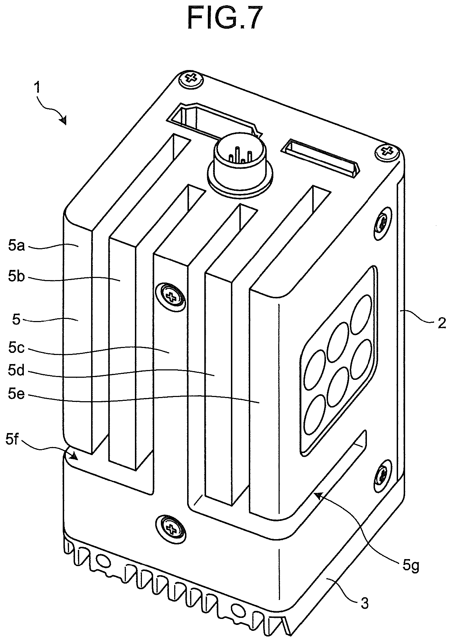

FIG. 7 is an external perspective view illustrating arrangement that is adopted when the electronic device 1 illustrated in FIG. 6 is used, in particular, when the electronic device 1 is used as a microscope camera or the like with the front cover 3 facing downward. In this use condition, the hollow fins 5a to 5e of the top cover 5 are arranged in the vertical direction, and air flows in from lower concave portions 5f and 5g and flows out from upper ends through the concave portions of the fins 5a to 5e; therefore, the heat dissipate effect is improved.

### Fourth Embodiment

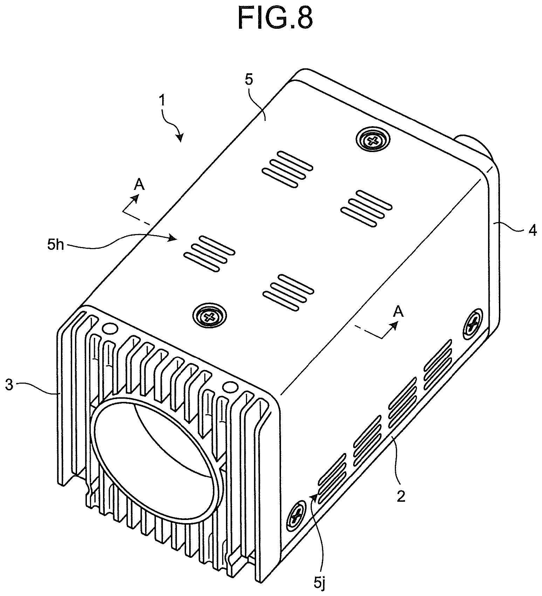

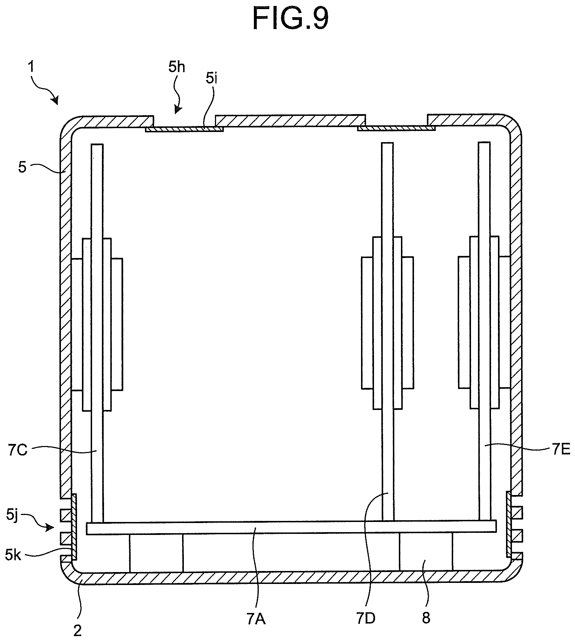

FIG. 8 is an external perspective view illustrating a configuration example of an electronic device 1 according to a fourth embodiment. In the fourth embodiment, hollow fins are not provided on the top cover 5 of the electronic device 1, but a plurality of air outlets 5h and air inlets 5j are provided instead. FIG. 9 is an end view taken along A-A in FIG. 8.

In FIG. 8 and FIG. 9, the electronic device 1 has a casing that is formed in an approximately rectangular box shape with the bottom cover 2 that constitutes a bottom surface and a part of side surfaces, the front cover 3 that constitutes a front surface, the back cover 4 that constitutes a back surface, and the top cover 5 that constitutes an upper surface and most of the side surfaces. In the casing of the electronic device 1, the substrate 7A is fixed with the spacer 8, and the substrates 7C, 7D, and 7E are fixed in the vertical direction on the substrate 7A. Configurations of the components other than the top cover 5 are the same as those illustrated in FIG. 1 etc.

The top cover 5 includes a flat top portion and left and right side plate portions. The plurality of air outlets 5h are provided on the top portion, and the plurality of air inlets 5h are provided on the side plate portions. Further, breathable sheets 5i with breathability, waterproof property, and dust resistance (which are waterproof, dust resistant, and breathable) are provided on the inner sides of the air outlets 5h so as to cover the air outlets 5h. Similarly, breathable sheets 5k with breathability, waterproof property, and dust resistance are provided on the inner sides of the air inlets 5j so as to cover the air inlets 5j. The breathable sheets 5i and 5k are configured with, for example, films with a large number of fine pores, or the like.

In this manner, by providing the air outlets 5h and the air inlets 5j covered with the breathable sheets 5i and 5k on the top cover 5, thermal convection occurs with heat that is generated by the electronic circuits 9 and the like of the substrates 7A, 7C, 7D, 7E, and the like inside the casing through the pathway of outside air , the air inlets 5j , inside of the casing → the air outlets 5h → outside air, so that the heat dissipate effect is improved. Further, ventilation is performed inside the casing, so that the technology is applicable to a device that needs ventilation (for example, a device using air battery that needs fresh air for operation, a device that generates some kind of gas, and the like).

Meanwhile, the breathable sheets 5i and 5k realize breathability, waterproof property, and dust resistance by a film provided with a large number of fine pores or the like, but have large flow resistance due to the viscosity of air under a condition in which airflow is stopped, and therefore, thermal convection may be impeded in some cases. To prevent the situation as described above, for example, it is preferable to reduce the opening areas of the air outlets 5h. It is possible to set adequately large opening areas for the air inlets 5j. For example, the following relationship is preferable: a sum of the opening areas of the air outlets 5h < a sum of the opening areas of the air inlets 5j. By reducing the opening areas of the air outlets 5h, air pressure around the air outlets 5h increases inside the casing and an air pressure difference with respect to the outside air occurs, so that air is likely to flow from the air outlets 5h to the outside. If the air outlets 5h and the air inlets 5j have the same size, it may be possible to reduce the number of the air outlets 5h as compared to the number of the air inlets 5j in order to produce a difference between the sums of the opening areas. With the occurrence of airflow, airflow resistance is reduced; therefore, airflow can be easily maintained even when air pressure around the air outlets 5h is reduced due to the airflow, and thus thermal convection occurs effectively. To increase the air pressure difference and improve the airflow, it is preferable to increase the height of the casing as much as possible.

### Fifth Embodiment

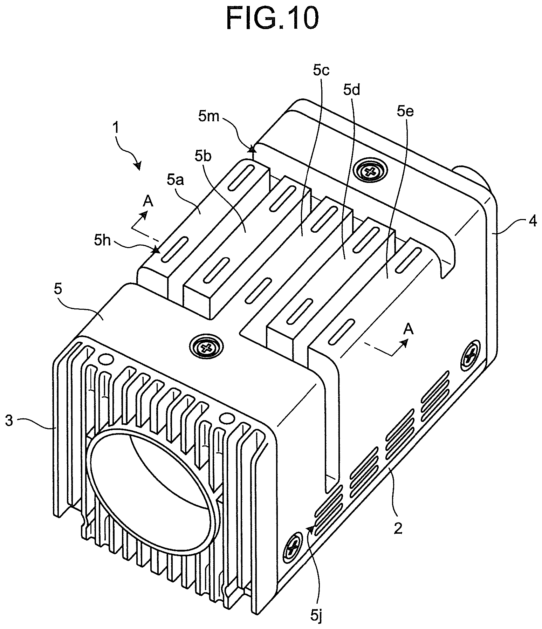

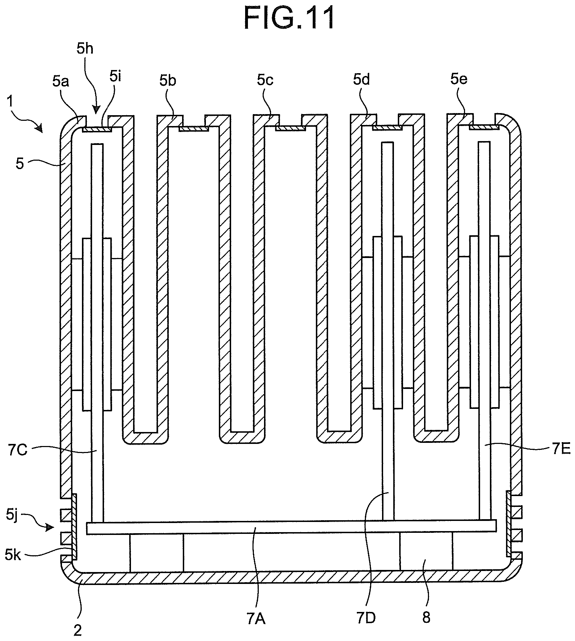

FIG. 10 is an external perspective view illustrating a configuration example of an electronic device 1 according to a fifth embodiment. The fifth embodiment is a combination of the first embodiment illustrated in FIG. 1 and the fourth embodiment illustrated in FIG. 8. FIG. 11 is an end view taken along A-A in FIG. 10.

In FIG. 10 and FIG. 11, the electronic device 1 has a casing that is formed in an approximately rectangular box shape with the bottom cover 2 that constitutes a bottom surface and a part of side surfaces, the front cover 3 that constitutes a front surface, the back cover 4 that constitutes a back surface, and the top cover 5 that constitutes an upper surface and most of the side surfaces. In the casing of the electronic device 1, the substrate 7A is fixed with the spacer 8, and the substrates 7C, 7D, and 7E are fixed in the vertical direction on the substrate 7A. Configurations of the components other than the top cover 5 are the same as those illustrated in FIG. 1 etc.

The hollow fins 5a to 5e are provided on the top cover 5 similarly to the configuration illustrated in FIG. 1, but a concave portion 5m is further provided across the fins 5a to 5e at a predetermined position from the back cover 4 side. Further, the plurality of air outlets 5h are provided on the upper surfaces of the fins 5a to 5e, and the plurality of air inlets 5j are provided in the lower parts of the side surfaces of the top cover 5. Furthermore, the breathable sheets 5i with breathability, waterproof property, and dust resistance are provided on the inner sides of the air outlets 5h so as to cover the air outlets 5h. Similarly, the breathable sheets 5k with breathability, waterproof property, and dust resistance are provided on the inner sides of the air inlets 5j so as to cover the air inlets 5j.

In this manner, by providing the air outlets 5h covered with the breathable sheets 5i on the upper surfaces of the hollow fins 5a to 5e of the top cover 5, and providing the air inlets 5j covered with the breathable sheets 5k in the lower parts of the side surface, the hollow fins 5a to 5e have the same configuration as a chimney pipe that increases thermal convection from the lower side to the upper side and improve the heat dissipate effect. Further, the concave portion 5m that is provided across the fins 5a to 5e divides upper portions of the respective fins 5a to 5e, so that heated air is likely to be accumulated. With this configuration, an air pressure difference with respect to the outside air is increased and flow toward the outside air is accelerated.

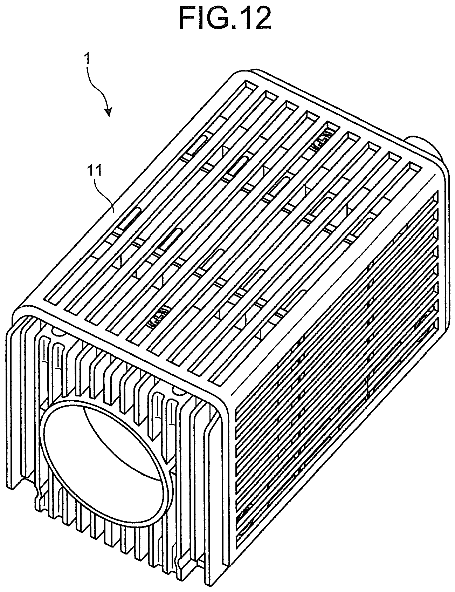

It may be possible to attach the burn prevention cover 11 even in the present embodiment. FIG. 12 is an external perspective view of a state in which the burn prevention cover 11 is attached to the electronic device 1. The burn prevention cover 11 illustrated in FIG. 5 and the burn prevention cover 11 illustrated in FIG. 12 have slightly different mesh patterns, but it is possible to adopt either one of the patterns or adopt still another pattern. That is, it is possible to adopt any configuration that ensures breathability and that prevents a user from directly touching a heated portion, such as the top cover 5, with his/her finger when the user touches the electronic device 1.

### Sixth Embodiment

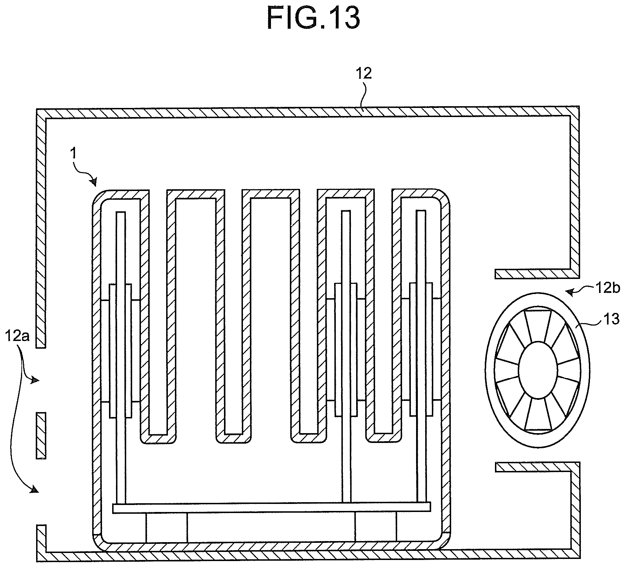

FIG. 13 to FIG. 15 are end views illustrating configuration examples of an electronic device 1 according to a sixth embodiment. In the sixth embodiment, any of the electronic device 1 according to the first and third embodiments as illustrated in FIG. 3A, the electronic device 1 according to the fourth embodiment as illustrated in FIG. 9, and the electronic device 1 according to the fifth embodiment as illustrated in FIG. 11 is cooled. The present embodiment is applicable to a case in which the electronic device 1 is incorporated into a larger electronic device that includes a cooling unit, or a case in which the electronic device 1 includes a cooling unit. Hereinafter, a case will be described in which the electronic device 1 is incorporated into a larger electronic device that includes a casing 12 and a cooling unit. The cooling unit includes, for example, a cooling fan 13 for blowing air into the casing 12.

In FIG. 13, the electronic device 1 of the first and third embodiments as illustrated in FIG. 3A is arranged inside the casing 12. Vents 12a are provided at one end of the casing 12, a vent 12b is provided at the other end of the casing 12, and the cooling fan 13 is provided at the vent 12b.

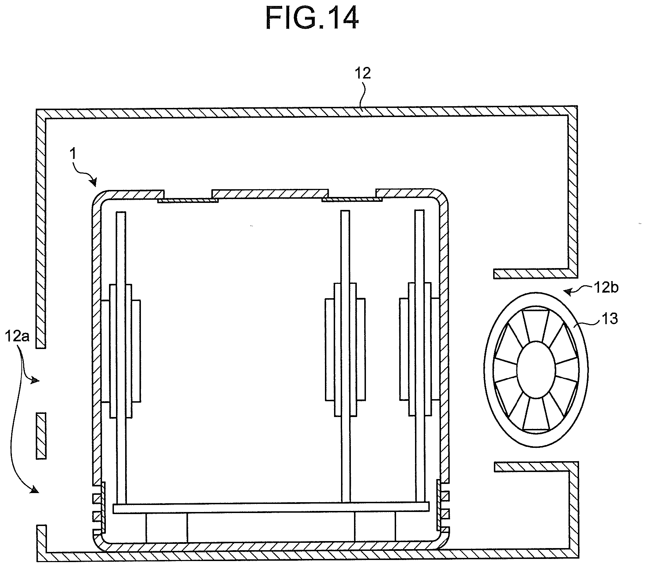

In FIG. 14, the electronic device 1 according to the fourth embodiment as illustrated in FIG. 9 is arranged inside the casing 12. The vents 12a are provided at one end of the casing 12, the vent 12b is provided at the other end of the casing 12, and the cooling fan 13 is provided at the vent 12b.

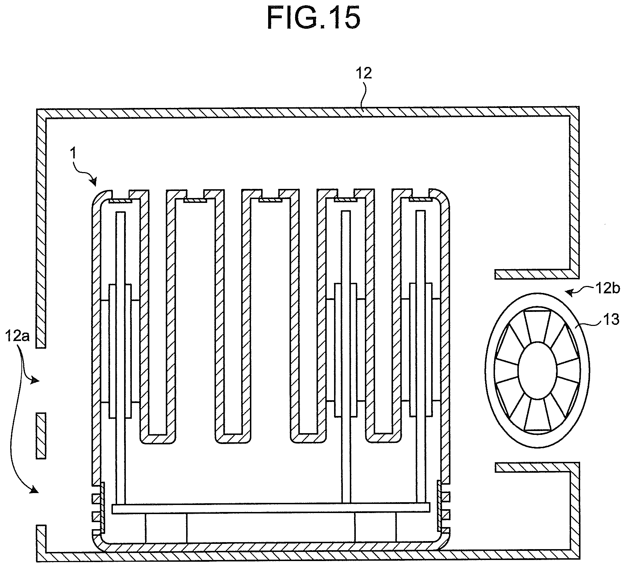

In FIG. 15, the electronic device 1 according to the fifth embodiment as illustrated in FIG. 11 is arranged inside the casing 12. The vents 12a are provided at one end of the casing 12, the vent 12b is provided at the other end of the casing 12, and the cooling fan 13 is provided at the vent 12b.

It is preferable to determine a positional relationship between the cooling fan 13 and the electronic device 1 such that the electronic device 1 can be effectively cooled. For example, when the electronic device 1 of the first embodiment is used, the positional relationship between the cooling fan 13 and the electronic device 1 is determined such that air from the cooling fan 13 reaches the third surface. For another example, when the electronic device 1 of the third embodiment is used, the positional relationship between the cooling fan 13 and the electronic device 1 is determined such that air from the cooling fan 13 reaches at least one of the second surface and the third surface. The electronic device 1 is forcibly cooled by the airflow generated by the cooling fan 13, so that it is possible to adequately cool the electronic device 1. Further, in general, when a cooling fan is used to cool an electronic circuit inside an electronic device, the electronic device or the cooling fan may be broken down due to the influence of dust caught on the cooling fan. However, by applying the present embodiment, it is possible to effectively dissipate heat while ensuring the sealing performance of the electronic device 1. As a result, it is possible to increase the opening areas of the vents 12a and 12b of the casing 12, so that dust is less likely to be accumulated at the vents 12a and 12b. Furthermore, the casing 12 may be configured in an openable and closable manner, and it may be possible to request a user to perform operation of removing dust or the like inside the casing 12. As a result, it is possible to prevent reduction of the cooling effect and prevent breakdown of the electronic circuit and the cooling fan.

According to at least one of the embodiments as described above, it is possible to effectively dissipate heat from the electronic device.

The electronic device 1 as described above is only limited by the appended claims. The technology is applicable to any electronic device that needs to dissipate heat. The electronic device 1 may be, for example, a medical device or a part of a medical device incorporating an image sensor.

## Claims

1. An electronic device (1) comprising:
a casing (2, 3, 4, 5) that includes a plurality of fins including hollow fins (5a, 5b, 5c, 5d, 5e); and
substrates (7C, 7D, 7E) inserted in the hollow fins the substrates including electronic circuits (9),
wherein each of the substrates (7C, 7D, 7E) is sandwiched between inner walls of each of the hollow fins (5a, 5d, and 5e) in a contact or non-contact manner, such that each of the substrates is inserted in one hollow fin of the hollow fins, wherein
the casing (2, 3, 4, 5) includes:
a first surface,
a second surface that faces the first surface,
a third surface that is perpendicular to the second surface,
a fourth surface that faces the third surface,
a fifth surface that is perpendicular to the first surface and the third surface,
a sixth surface that faces the fifth surface,
a first member (5) that corresponds to at least the third surface, the fifth surface, and the sixth surface and that includes the plurality of fins (5a, 5b, 5c, 5d, 5e), and
a second member (2) that corresponds to the fourth surface, and
the substrates (7C, 7D, 7E) are fixed to the second member, and the electronic device further comprises
an image sensor that is arranged along the first surface of the casing (2, 3, 4, 5), that is connected to the electronic circuits (9), and that has a light receiving surface, and
wherein the substrates (7C, 7D, 7E) are perpendicular to the light receiving surface.

2. An electronic device (1) comprising:
a casing (2, 3, 4, 5) that includes a plurality of fins including hollow fins (5a, 5b, 5c, 5d, 5e); and
substrates (7C, 7D, 7E) inserted in the hollow fins the substrates including electronic circuits (9),
wherein each of the substrates (7C, 7D, 7E) is sandwiched between inner walls of each of the hollow fins (5a, 5d, and 5e) in a contact or non-contact manner, such that each of the substrates is inserted in one hollow fin of the hollow fins, wherein
the casing (2, 3, 4, 5) includes:
a first surface,
a second surface that faces the first surface,
a third surface that is perpendicular to the second surface,
a fourth surface that faces the third surface,
a fifth surface that is perpendicular to the first surface and the third surface, and
a sixth surface that faces the fifth surface, and
the electronic device further comprising:
a mesh-like cover (11) that covers at least the third surface, the fifth surface, and the sixth surface, and the electronic device further comprises
an image sensor that is arranged along the first surface of the casing (2, 3, 4, 5), that is connected to the electronic circuits (9), and that has a light receiving surface, and
wherein the substrates (7C, 7D, 7E) are perpendicular to the light receiving surface.

3. An electronic device (1) comprising:
a casing (2, 3, 4, 5) that includes a plurality of fins including hollow fins (5a, 5b, 5c, 5d, 5e); and
substrates (7C, 7D, 7E) inserted in the hollow fins the substrates including electronic circuits (9),
wherein each of the substrates (7C, 7D, 7E) is sandwiched between inner walls of each of the hollow fins (5a, 5d, and 5e) in a contact or non-contact manner, such that each of the substrates is inserted in one hollow fin of the hollow fins, wherein
the casing (2, 3, 4, 5) includes:
a first surface,
a second surface that faces the first surface,
a third surface that is perpendicular to the second surface,
a fourth surface that faces the third surface,
a fifth surface that is perpendicular to the first surface and the third surface, and
a sixth surface that faces the fifth surface,
end surfaces of the plurality of fins are included in the third surface, and
side surfaces of the plurality of fins are parallel to the fifth surface and the sixth surface, and the electronic device further comprises
an image sensor that is arranged along the first surface of the casing (2, 3, 4, 5), that is connected to the electronic circuits (9), and that has a light receiving surface, and
wherein the substrates (7C, 7D, 7E) are perpendicular to the light receiving surface

4. The electronic device (1) according to any one of claims 1 to 3, wherein the substrates (7C, 7D, 7E) are arranged approximately parallel to the inner walls of the hollow fins (5a, 5b, 5c, 5d, 5e).

5. The electronic device (1) according to any one of claims 1 to 3, further comprising heat-transfer members (10) that are arranged between the inner walls of the hollow fins (5a, 5b, 5c, 5d, 5e) and the substrates (7C, 7D, 7E), and that come in contact with the inner walls of the hollow fins and the substrates.

6. The electronic device (1) according to claim 5, wherein, in the hollow fin (5a, 5e) located on an outer side inside the casing (2, 3, 4, 5) among the hollow fins (5a, 5b, 5c, 5d, 5e), a surface of the substrate (7C, 7E) facing the outer side of the casing does not come in contact with the inner wall of the hollow fin.

7. The electronic device (1) according to claim 1, further comprising a mesh-like cover (11) that covers at least the third surface, the fifth surface, and the sixth surface.

8. The electronic device (1) according to any one of claims 1 to 7, wherein
an air inlet (5j) for taking air into the casing (2, 3, 4, 5) is provided on at least one of the fifth surface and the sixth surface of the casing, and
an air outlet (5h) for discharging air from inside of the casing is provided on the third surface of the casing.

9. The electronic device (1) according to claim 8, further comprising sheets (5k, 5i) that have breathability, waterproof property, and dust resistance and cover the air inlet (5j) and the air outlet (5h).

10. The electronic device (1) according to any of claims 1 to 3 further comprising a cooling unit (13) that cools the casing (2, 3, 4, 5).

## Patentansprüche

1. Elektronische Vorrichtung (1) mit:
einem Gehäuse (2, 3, 4, 5), das eine Vielzahl von Rippen hat, mit Hohlrippen (5a, 5b, 5c, 5d, 5e); und
Substraten (7C, 7D, 7E), die in die Hohlrippen eingesetzt sind, wobei die Substrate elektronische Schaltungen (9) haben,
wobei jedes der Substrate (7C, 7D, 7E) zwischen Innenwänden jeder der Hohlrippen (5a, 5d und 5e) in einer Weise mit oder ohne Berührung angeordnet ist, dass jedes der Substrate in eine Hohlrippe der Hohlrippen eingesetzt ist, wobei
das Gehäuse (2, 3, 4, 5) hat:
eine erste Oberfläche,
eine zweite Oberfläche, die der ersten Oberfläche zugewandt ist,
eine dritte Oberfläche, die senkrecht zur zweiten Oberfläche liegt,
eine vierte Oberfläche, die der dritten Oberfläche zugewandt ist,
eine fünfte Oberfläche, die senkrecht zur ersten Oberfläche und zur dritten Oberfläche liegt,
eine sechste Oberfläche, die der fünften Oberfläche zugewandt ist,
ein erstes Element (5), das mindestens der dritten Oberfläche, der fünften Oberfläche und der sechsten Oberfläche entspricht und das eine Vielzahl von Rippen (5a, 5b, 5c, 5d, 5e) hat, und
ein zweites Element (2), das der vierten Oberfläche entspricht, und
die Substrate (7C, 7D, 7E) sind an dem zweiten Element befestigt, und die elektronische Vorrichtung hat ferner einen Bildsensor, der entlang der ersten Oberfläche des Gehäuses (2, 3, 4, 5) angeordnet ist, der mit den elektronischen Schaltungen (9) verbunden ist und der eine Lichtempfangsoberfläche aufweist, und
wobei die Substrate (7C, 7D, 7E) senkrecht zur Lichtempfangsoberfläche sind.

2. Elektronische Vorrichtung (1) mit:
einem Gehäuse (2, 3, 4, 5), das eine Vielzahl von Rippen hat, mit Hohlrippen (5a, 5b, 5c, 5d, 5e); und
Substraten (7C, 7D, 7E), die in die Hohlrippen eingesetzt sind, wobei die Substrate elektronische Schaltungen (9) haben,
wobei jedes der Substrate (7C, 7D, 7E) zwischen Innenwänden jeder der Hohlrippen (5a, 5d und 5e) in einer berührenden oder nicht berührenden Weise angeordnet ist, so dass jedes der Substrate in eine Hohlrippe der Hohlrippen eingesetzt ist, wobei
das Gehäuse (2, 3, 4, 5) hat:
eine erste Oberfläche,
eine zweite Oberfläche, die der ersten Oberfläche zugewandt ist,
eine dritte Oberfläche, die senkrecht zur zweiten Oberfläche liegt,
eine vierte Oberfläche, die der dritten Oberfläche zugewandt ist,
eine fünfte Oberfläche, die senkrecht zur ersten Oberfläche und zur dritten Oberfläche liegt, und
eine sechste Oberfläche, die der fünften Oberfläche zugewandt ist, und
die elektronische Vorrichtung ferner hat:
eine netzartige Abdeckung (11), die wenigstens die dritte Oberfläche, die fünfte Oberfläche und die sechste Oberfläche abdeckt, und die elektronische Vorrichtung ferner hat
einen Bildsensor, der entlang der ersten Oberfläche des Gehäuses (2, 3, 4, 5) angeordnet ist, der mit den elektronischen Schaltungen (9) verbunden ist und der eine Lichtempfangsoberfläche aufweist, und
wobei die Substrate (7C, 7D, 7E) senkrecht zur Lichtempfangsoberfläche stehen.

3. Elektronische Vorrichtung (1) mit:
einem Gehäuse (2, 3, 4, 5), das eine Vielzahl von Rippen hat, mit Hohlrippen (5a, 5b, 5c, 5d, 5e); und
Substraten (7C, 7D, 7E), die in die Hohlrippen eingesetzt sind, wobei die Substrate elektronische Schaltungen (9) haben,
wobei jedes der Substrate (7C, 7D, 7E) zwischen Innenwänden jeder der Hohlrippen (5a, 5d und 5e) in einer berührenden oder nicht berührenden Weise angeordnet ist, so dass jedes der Substrate in eine Hohlrippe der Hohlrippen eingesetzt ist, wobei
das Gehäuse (2, 3, 4, 5) hat:
eine erste Oberfläche,
eine zweite Oberfläche, die der ersten Oberfläche zugewandt ist,
eine dritte Oberfläche, die senkrecht zur zweiten Oberfläche ist,
eine vierte Oberfläche, die der dritten Oberfläche zugewandt ist,
eine fünfte Oberfläche, die senkrecht zur ersten Oberfläche und zur dritten Oberfläche ist, und
eine sechste Oberfläche, die der fünften Oberfläche zugewandt ist,
Endflächen der Vielzahl von Rippen in der dritten Oberfläche liegen und
die Seitenflächen der Vielzahl von Rippen parallel zur fünften und zur sechsten Oberfläche liegen, und die elektronische Vorrichtung ferner einen Bildsensor hat, der entlang der ersten Oberfläche des Gehäuses (2, 3, 4, 5) angeordnet ist, der mit den elektronischen Schaltungen (9) verbunden ist und der eine Lichtempfangsoberfläche aufweist, und
wobei die Substrate (7C, 7D, 7E) senkrecht zur Lichtempfangsoberfläche liegen

4. Elektronische Vorrichtung (1) gemäß einem der Ansprüche 1 bis 3, wobei die Substrate (7C, 7D, 7E) ungefähr parallel zu den Innenwänden der Hohlrippen (5a, 5b, 5c, 5d, 5e) angeordnet sind.

5. Elektronische Vorrichtung (1) gemäß einem der Ansprüche 1 bis 3, die ferner Wärmeübertragungselemente (10) hat, die zwischen den Innenwänden der Hohlrippen (5a, 5b, 5c, 5d, 5e) und den Substraten (7C, 7D, 7E) angeordnet sind und mit den Innenwänden der Hohlrippen und den Substraten in Berührung kommen.

6. Elektronische Vorrichtung (1) gemäß Anspruch 5, wobei in der Hohlrippe (5a, 5e), die sich auf einer außenliegenden Seite innerhalb des Gehäuses (2, 3, 4, 5) unter den Hohlrippen (5 a, 5b, 5c, 5d, 5e) eine der außenliegenden Seite des Gehäuses zugewandte Oberfläche des Substrats (7C, 7E) nicht in Berührung mit der Innenwand der Hohlrippe kommt.

7. Die elektronische Vorrichtung (1) gemäß Anspruch 1, die ferner eine netzartige Abdeckung (11) hat, die mindestens die dritte Oberfläche, die fünfte Oberfläche und die sechste Oberfläche abdeckt.

8. Elektronische Vorrichtung (1) gemäß einem der Ansprüche 1 bis 7, wobei
ein Lufteinlass (5j) zum Einlassen von Luft in das Gehäuse (2, 3, 4, 5) auf mindestens einer der fünften und sechsten Oberfläche des Gehäuses bereitgestellt ist und
ein Luftauslass (5h) zum Ablassen von Luft aus dem Inneren des Gehäuses auf der dritten Oberfläche des Gehäuses bereitgestellt ist.

9. Elektronische Vorrichtung (1) gemäß Anspruch 8, die außerdem Lagen (5k, 5i) aufweist, die Atmungsaktivität, Wasserdichtigkeit und Staubbeständigkeit aufweisen und den Lufteinlass (5j) und den Luftauslass (5h) abdecken.

10. Elektronische Vorrichtung (1) gemäß einem der Ansprüche 1 bis 3, die außerdem eine Kühleinheit (13) aufweist, die das Gehäuse (2, 3, 4, 5) kühlt.

## Revendications

1. Dispositif électronique (1) comprenant :
un boîtier (2, 3, 4, 5) qui comporte une pluralité d'ailettes dont des ailettes creuses (5a, 5b, 5c, 5d, 5e) ; et
des substrats (7C, 7D, 7E) insérés dans les ailettes creuses, les substrats comportant des circuits électroniques (9),
dans lequel chacun des substrats (7C, 7D, 7E) est pris en sandwich entre des parois internes de chacune des ailettes creuses (5a, 5d, et 5e) d'une manière avec contact ou sans contact, de sorte que chacun des substrats soit inséré dans une ailette creuse parmi les ailettes creuses, dans lequel
le boîtier (2, 3, 4, 5) comporte :
une première surface,
une deuxième surface qui fait face à la première surface,
une troisième surface qui est perpendiculaire à la deuxième surface,
une quatrième surface qui fait face à la troisième surface,
une cinquième surface qui est perpendiculaire à la première surface et à la troisième surface,
une sixième surface qui fait face à la cinquième surface,
un premier organe (5) qui correspond au moins à la troisième surface, à la cinquième surface et à la sixième surface et qui comporte la pluralité d'ailettes (5a, 5b, 5c, 5d, 5e), et
un deuxième organe (2) qui correspond à la quatrième surface, et
les substrats (7C, 7D, 7E) sont fixés au deuxième organe,
et le dispositif électronique comprend en outre un capteur d'image qui est agencé le long de la première surface du boîtier (2, 3, 4, 5), qui est connecté aux circuits électroniques (9), et qui possède une surface de réception de lumière, et
dans lequel les substrats (7C, 7D, 7E) sont perpendiculaires à la surface de réception de lumière.

2. Dispositif électronique (1) comprenant :
un boîtier (2, 3, 4, 5) qui comporte une pluralité d'ailettes dont des ailettes creuses (5a, 5b, 5c, 5d, 5e) ; et
des substrats (7C, 7D, 7E) insérés dans les ailettes creuses, les substrats comportant des circuits électroniques (9),
dans lequel chacun des substrats (7C, 7D, 7E) est pris en sandwich entre des parois internes de chacune des ailettes creuses (5a, 5d, et 5e) d'une manière avec contact ou sans contact, de sorte que chacun des substrats soit inséré dans une ailette creuse parmi les ailettes creuses, dans lequel
le boîtier (2, 3, 4, 5) comporte :
une première surface,
une deuxième surface qui fait face à la première surface,
une troisième surface qui est perpendiculaire à la deuxième surface,
une quatrième surface qui fait face à la troisième surface,
une cinquième surface qui est perpendiculaire à la première surface et à la troisième surface, et
une sixième surface qui fait face à la cinquième surface, et
le dispositif électronique comprenant en outre :
un revêtement de type grille (11) qui recouvre au moins la troisième surface, la cinquième surface et la sixième surface, et le dispositif électronique comprend en outre un capteur d'image qui est agencé le long de la première surface du boîtier (2, 3, 4, 5), qui est connecté aux circuits électroniques (9), et qui possède une surface de réception de lumière, et
dans lequel les substrats (7C, 7D, 7E) sont perpendiculaires à la surface de réception de lumière.

3. Dispositif électronique (1) comprenant :
un boîtier (2, 3, 4, 5) qui comporte une pluralité d'ailettes dont des ailettes creuses (5a, 5b, 5c, 5d, 5e) ; et
des substrats (7C, 7D, 7E) insérés dans les ailettes creuses, les substrats comportant des circuits électroniques (9),
dans lequel chacun des substrats (7C, 7D, 7E) est pris en sandwich entre des parois internes de chacune des ailettes creuses (5a, 5d, et 5e) d'une manière avec contact ou sans contact, de sorte que chacun des substrats soit inséré dans une ailette creuse parmi les ailettes creuses, dans lequel
le boîtier (2, 3, 4, 5) comporte :
une première surface,
une deuxième surface qui fait face à la première surface,
une troisième surface qui est perpendiculaire à la deuxième surface,
une quatrième surface qui fait face à la troisième surface,
une cinquième surface qui est perpendiculaire à la première surface et à la troisième surface, et
une sixième surface qui fait face à la cinquième surface,
les surfaces d'extrémité de la pluralité d'ailettes sont comprises dans la troisième surface, et
les surfaces latérales de la pluralité d'ailettes sont parallèles à la cinquième surface et à la sixième surface,
et le dispositif électronique comprend en outre un capteur d'image qui est agencé le long de la première surface du boîtier (2, 3, 4, 5), qui est connecté aux circuits électroniques (9), et qui possède une surface de réception de lumière, et
dans lequel les substrats (7C, 7D, 7E) sont perpendiculaires à la surface de réception de lumière.

4. Dispositif électronique (1) selon l'une quelconque des revendications 1 à 3, dans lequel les substrats (7C, 7D, 7E) sont agencés de manière approximativement parallèle aux parois internes des ailettes creuses (5a, 5b, 5c, 5d, 5e) .

5. Dispositif électronique (1) selon l'une quelconque des revendications 1 à 3, comprenant en outre des organes de transfert de chaleur (10) qui sont agencés entre les parois internes des ailettes creuses (5a, 5b, 5c, 5d, 5e) et les substrats (7C, 7D, 7E), et qui viennent en contact avec les parois internes des ailettes creuses et les substrats.

6. Dispositif électronique (1) selon la revendication 5, dans lequel, dans l'ailette creuse (5a, 5e) située sur un côté externe à l'intérieur du boîtier (2, 3, 4, 5) parmi les ailettes creuses (5a, 5b, 5c, 5d, 5e), une surface du substrat (7C, 7E) faisant face au côté externe du boîtier ne vient pas en contact avec la paroi interne de l'ailette creuse.

7. Dispositif électronique (1) selon la revendication 1, comprenant en outre un revêtement de type grille (11) qui recouvre au moins la troisième surface, la cinquième surface et la sixième surface.

8. Dispositif électronique (1) selon l'une quelconque des revendications 1 à 7, dans lequel
une entrée d'air (5j) pour l'admission d'air dans le boîtier (2, 3, 4, 5) est prévue sur au moins l'une parmi la cinquième surface et la sixième surface du boîtier, et une sortie d'air (5h) pour le refoulement d'air depuis l'intérieur du boîtier est prévue sur la troisième surface du boîtier.

9. Dispositif électronique (1) selon la revendication 8, comprenant en outre des lames (5k, 5i) qui possèdent une respirabilité, une propriété imperméable et une résistance à la poussière et recouvrent l'entrée d'air (5j) et la sortie d'air (5h).

10. Dispositif électronique (1) selon l'une quelconque des revendications 1 à 3 comprenant en outre une unité de refroidissement (13) qui refroidit le boîtier (2, 3, 4, 5) .
